# EUROPEAN PATENT APPLICATION

(11) **EP 2 239 654 A2**
(43) Date of publication of application: **13.10.2010**
(21) Application number: 10158089.2
(22) Date of filing: 26.03.2010
(51) Int. Cl.: G06F 3/06

(54) **Memory systems for computing devices and systems**

(30) Priority: 10.04.2009 US 421848
(71) Applicant: Honeywell International Inc., Morristown, NJ 07962 (US)
(72) Inventor: Becker, Eric, Morristown, NJ 07962-2245 (US); Carmichael, Rick, Morristown, NJ 07962-2245 (US); Keller, Brian, Morristown, NJ 07962-2245 (US); Gavagan, Vince J., Morristown, NJ 07962-2245 (US); Fiedler, William A., Morristown, NJ 07962-2245 (US); Marshall, Richard, Morristown, NJ 07962-2245 (US)
(74) Representative: Buckley, Guy Julian

(57) **Abstract**

Memory systems and devices are provided. One memory system (300) includes a controller (310) configured to be coupled to a plurality of computing devices (410), a plurality of Multi-Level Cell (MLC) devices coupled to the controller (310), and a Single-Level Cell (SLC) device coupled to the controller (310) and the plurality of MLC devices. The MLC devices are configured to split the storage of data across the plurality of MLC devices and the SLC device is configured to function as a parity device for the data. A memory device (100) includes a controller (310), a plurality of MLC FLASH devices, and a SLC FLASH device. The MLC FLASH devices are configured to split the storage of data across the plurality of MLC FLASH devices and the SLC FLASH device is configured to function as a parity device for the data. Also provided are computing devices (410) including the above memory device (100).

## Description

### FIELD OF THE INVENTION

The present invention generally relates to computing systems and devices, and more particularly relates to memory systems for use in computing systems and devices.

### BACKGROUND OF THE INVENTION

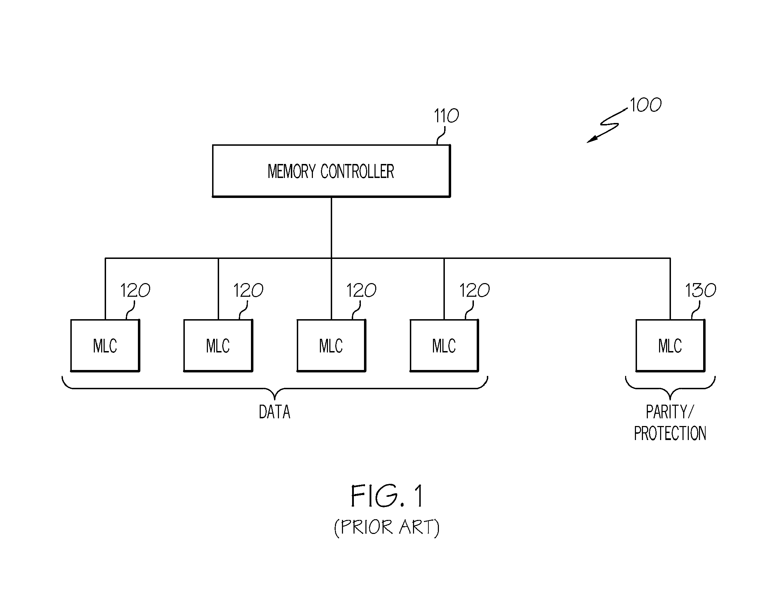

FIG. 1 is a block diagram of a prior art memory system 100. Memory system 100 includes a memory controller 110, a plurality of data storage devices 120 connected to memory controller 110, and a parity or protection device 130 (error detection/correction device) connected to memory controller 110 and data storage devices 120.

Here, each data storage device 120 and parity device 130 is a Multi-Level Cell (MLC) memory disk or flash device. In a level 3 or level 4 Redundant Array of Independent Disks (RAID 3 or RAID 4, respectively) arrangement or a level 3 or level 4 Redundant Array of Independent Flash (RAIF 3 or RAIF 4, respectively) arrangement, as data is written to data storage devices 120 in a striped fashion, the data is also written to parity device 130. That is, data is written into parity device 130 a significantly greater number of times than to each of data storage devices 120 individually.

Since data is written into parity device 130 a significantly greater number of times than to each of data storage devices 120, parity device 130 wears out faster than each of data storage devices 120. As a result, memory device 100 includes a relatively limited life span and/or may experience reliability issues, even though MLC memory devices (i.e., disks and flash devices) are relatively inexpensive as compared to Single-Level Cell (SLC) devices (e.g., disks and flash devices).

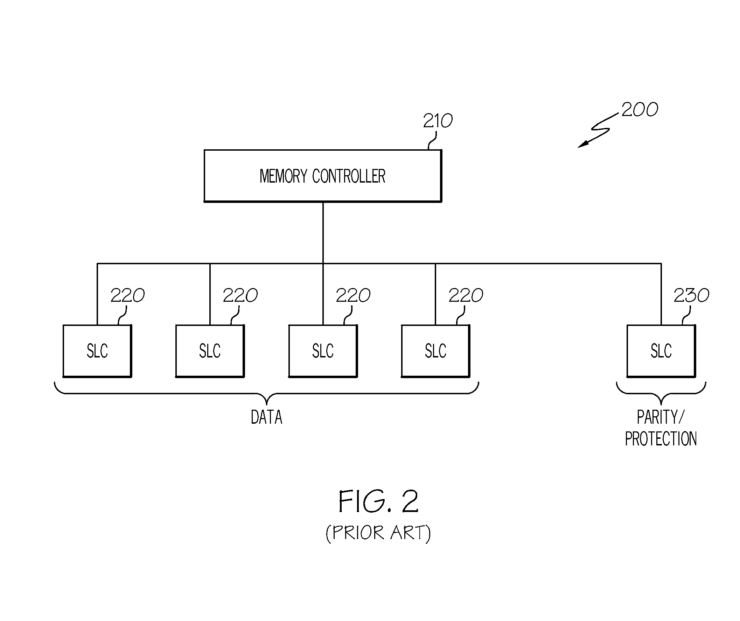

FIG. 2 is a block diagram of another prior art memory system 200. Memory system 200 includes a memory controller 210, a plurality of data storage devices 220 connected to memory controller 210, and a parity or protection device 230 (error detection/correction device) connected to memory controller 210 and data storage devices 220.

Here, each data storage device 220 and parity device 230 is a SLC memory disk or flash device. Since data storage devices 220 and parity device 230 are each SLC devices, data storage devices 220 and parity device 230 will not wear out as quickly and are less likely to experience the same reliability issues as storage system 100 in FIG. 1 because SLC devices are capable of handling up to 10 times the amount of write cycles as an MLC device. A drawback to memory system 200 using SLC devices for both data storage devices 220 and parity device 230 is that SLC devices are expensive as compared to MLC devices.

Accordingly, it is desirable to provide memory systems that include a greater life expectancy, include greater reliability, and/or are less expensive than prior art memory systems. Furthermore, other desirable features and characteristics of the present invention will become apparent from the subsequent detailed description of the invention and the appended claims, taken in conjunction with the accompanying drawings and this

### background of the invention.

### BRIEF SUMMARY OF THE INVENTION

Various embodiments provide memory systems for storing data from a plurality of computing devices. One memory system comprises a controller configured to be coupled to the plurality of computing devices, a plurality of Multi-Level Cell (MLC) storage disks coupled to the controller, and a Single-Level Cell (SLC) storage disk coupled to the controller and the plurality of MLC storage disks. The MLC storage disks are configured to split storage of the data across the plurality of MLC storage disks and the SLC storage disk is a parity storage disk for the data.

Also provided are memory devices for a computer. One memory device comprises a controller, a plurality of MLC devices coupled to the controller, and a SLC device coupled to the controller and the plurality of MLC devices. The MLC devices are configured to split storage of the data across the plurality of MLC devices and the SLC device is a parity storage disk for the data.

Computing devices comprising a processor and memory coupled to the processor are also provided. The memory comprises a memory controller, a plurality of MLC devices coupled to the memory controller, and a SLC device coupled to the memory controller and the plurality of MLC devices. The MLC devices are configured to split storage of the data across the plurality of MLC devices and the SLC device is a parity storage disk for the data.

### BRIEF DESCRIPTION OF THE DRAWINGS

The present invention will hereinafter be described in conjunction with the following drawing figures, wherein like numerals denote like elements, and

FIG. 1 is a block diagram of a prior art memory system;

FIG. 2 is a block diagram of another prior art memory system;

FIG. 3 is a block diagram of a memory system in accordance with one embodiment of the present invention;

FIG. 4 is a diagram of one embodiment of a computing network comprising one embodiment of the memory system of FIG. 3; and

FIG. 5 is a block diagram of an embodiment of a computing device comprising embodiments of the memory system of FIG. 3.

### DETAILED DESCRIPTION OF THE INVENTION

The following detailed description of the invention is merely exemplary in nature and is not intended to limit the invention or the application and uses of the invention. Furthermore, there is no intention to be bound by any theory presented in the preceding background of the invention or the following detailed description of the invention.

Various embodiments provide memory systems that include a greater life expectancy, include greater reliability, and/or are less expensive than contemporary memory systems. That is, various embodiments provide memory systems that use a plurality of Multi-Level Cell (MLC) devices and a Single-Level Cell (SLC) device. Specifically, the MLC devices are used to store data written across the MLC devices, and the SLC device is used as a parity or protection device (e.g., an error detection/correction device) for the data written to the MLC devices. In this manner, it is believed that the various memory system embodiments provide a substitute for level 5 Redundant Array of Independent Disk (RAID 5) and level 5 Redundant Array of Independent FLASH (RAIF 5) configurations.

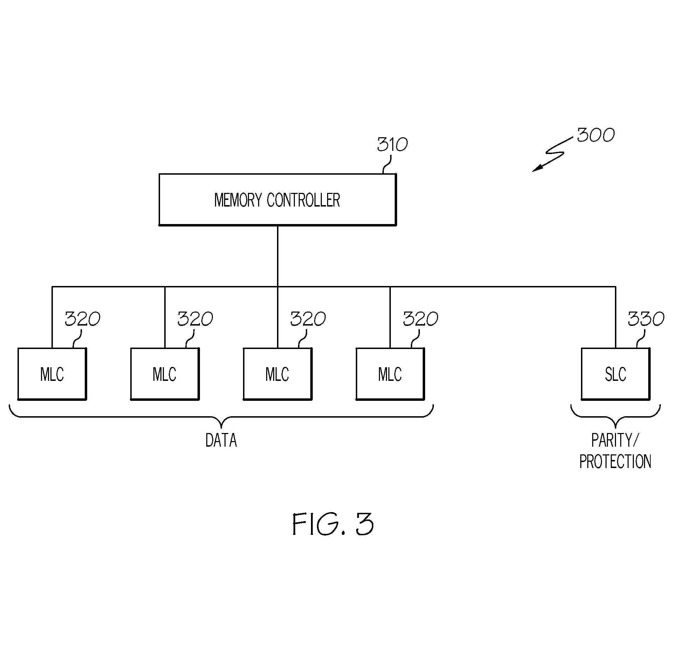

Returning to the figures, FIG. 3 is a memory system 300 in accordance with one embodiment of the present invention. At least in the illustrated embodiment, memory system 300 comprises a memory controller 310, a plurality of data storage devices 320 coupled to memory controller 310, and a parity or protection device 330 (error detection/correction device) coupled to memory controller 310 and data storage devices 320.

Data storage devices 320 are each a MLC memory disk or FLASH device. MLC memory disks and MLC FLASH devices are well known in the art and, as such, are not described in detail herein.

Parity device 330 is a SLC memory disk or FLASH device. SLC memory disks and SLC FLASH devices are well known in the art and, as such, are not described in detail herein.

Parity device 330 may utilize any protection scheme known in the art or developed in the future. For example, parity device 330 may be configured to use a Reed-Solomon protection scheme, an EDAC Hamming protection scheme, a XORing protection scheme, and/or the like protection scheme.

In one embodiment where data storage devices 320 are MLC memory disks and parity device 330 is a SLC memory disk, memory system 300 is configured to store data in a manner consistent with a level 3 Redundant Array of Independent Disk (RAID 3) configuration.

In another embodiment where data storage devices 320 are MLC memory disks and parity device 330 is a SLC memory disk, memory system 300 is configured to store data in a manner consistent with a level 4 Redundant Array of Independent Disk (RAID 4) configuration.

In one embodiment where data storage devices 320 are MLC FLASH devices and parity device 330 is a SLC FLASH device, memory system 300 is configured to store data in a manner consistent with a level 3 Redundant Array of Independent FLASH (RAIF 3) configuration.

In another embodiment where data storage devices 320 are MLC FLASH devices and parity device 330 is a SLC FLASH device, memory system 300 is configured to store data in a manner consistent with a level 4 Redundant Array of Independent FLASH (RAIF 4) configuration.

The functionality of RAID 3 and RAID 4 configurations is known in the art and, as such, is not described in detail herein. Similarly, the functionality of RAIF 3 and RAIF 4 configurations is known in the art and, as such, is not described in detail herein.

Although FIG. 3 illustrates memory system 300 as comprising four data storage devices 320, various other embodiments of memory system 300 may include two or three data storage devices 320. Similarly, various other embodiments of memory system 300 may include more than four data storage devices 320.

In certain embodiments, memory system 300 includes less than ten data storage devices 320 since, as discussed above, a SLC memory device is capable being written into about ten times more than a MLC memory device. In these embodiments, the reliability of memory system 300 is maintained because parity device 330 is capable of being written into a greater number of times than data storage devices 320, collectively. In other embodiments, memory system 300 includes ten data storage devices 320 so that parity device 330 is capable of being written into approximately an equal number of times as data storage devices 320, collectively.

Memory system 300 may be formed on any medium capable of containing memory system 300. One embodiment of memory system 300 is formed on a mass storage circuit card. That is, the mass storage circuit card is populated with controller 310, data storage devices 320, and parity device 330.

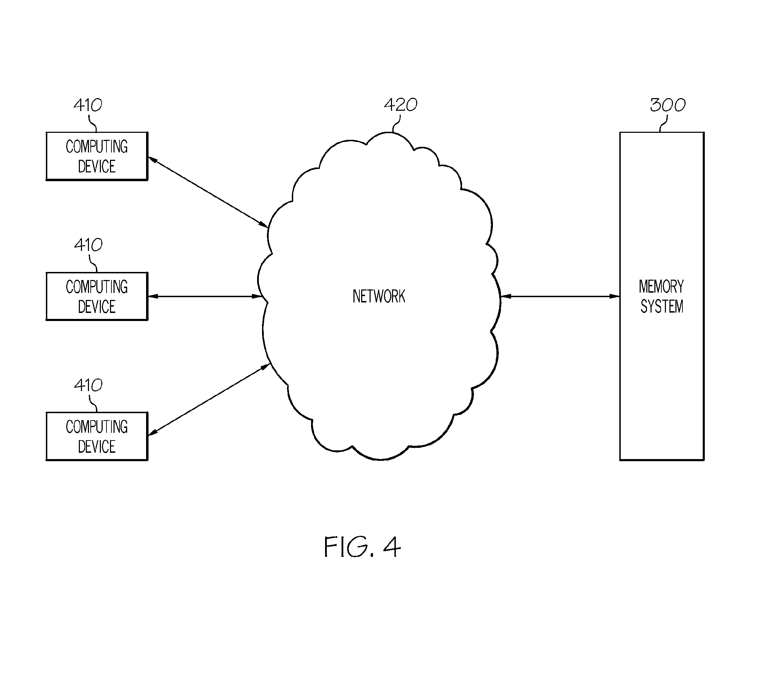

FIG. 4 is a diagram of one embodiment of a computing network 400using a network-attached memory system. At least in the illustrated embodiment, computing network 400 comprises a plurality of computing devices 410 in communication with memory system 300 via a network 420.

Computing devices 410 may be any computing device known in the art or developed in the future. For example, each computing device 410 may be a personal computer (e.g., a laptop, a notebook, a desktops, and/or the like), a personal digital assistant (PDA), a Blackberry^{®}, a cellular telephone, and the like computing devices, and combinations thereof.

Network 420 may be any communication medium that enables computing devices 410 to communicate with and store data within memory system. For example, network 420 may be the Internet, a local area network (LAN), a wide area network (WAN), and/or the like networks.

In the embodiment illustrated in FIG. 4, the plurality of data storage devices 320 in memory system 300 are MLC memory disks. Likewise, parity device 330 is a SLC memory disk.

Furthermore, memory system 300 is configured to store data in accordance with the functionality and principles of a RAID 3 or RAID 4 configuration. That is, data may be written across data storage devices 320 using byte-level striping (i.e., RAID 3) or using block-level striping (i.e., RAID 4).

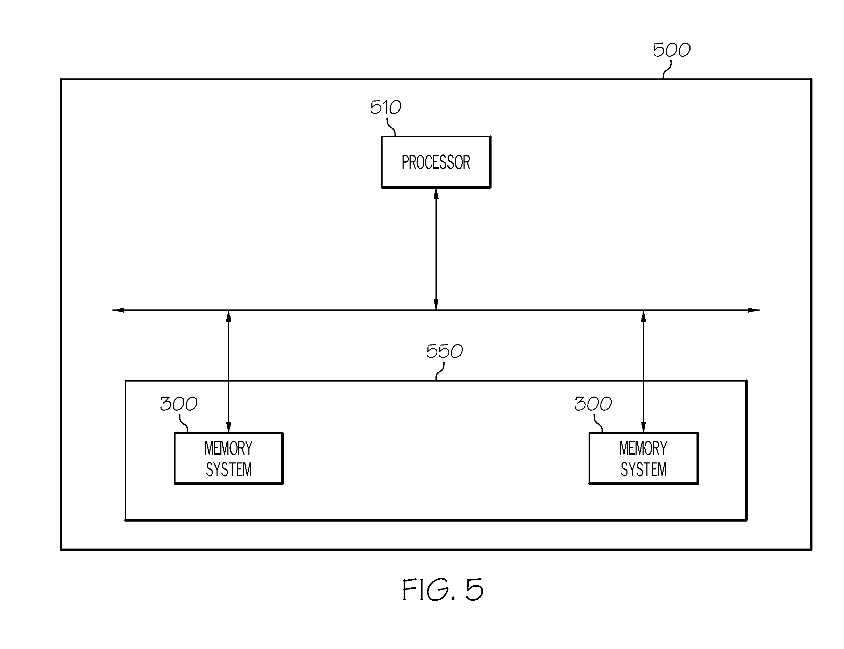

FIG. 5 is a diagram of one embodiment of a computing device 500. At least in the illustrated embodiment, computing device 500 comprises a processor 510 in communication with one or more memory systems 300.

Computing device 500 may be any computing device known in the art or developed in the future. For example, computing device 500 may be a personal computer (e.g., a laptop, a notebook, a desktops, and/or the like), a personal digital assistant (PDA), a Blackberry^{®}, a cellular telephone, or the like computing device. As such, processor 510 may be any processor known in the art or developed in the future.

In the embodiment illustrated in FIG. 5, the plurality of data storage devices 320 in memory system 300 are MLC FLASH devices. Likewise, parity device 330 is a SLC FLASH device.

Furthermore, memory system 300 is configured to store data in accordance with the functionality and principles of a RAIF 3 or RAIF 4 configuration. That is, data may be written across data storage devices 320 using byte-level striping (i.e., RAIF 3) or using block-level striping (i.e., RAIF 4).

In one embodiment, computing device 500 uses a plurality of memory systems 300 in place of a hard drive. That is, this embodiment of computing device 500 replaces a traditional hard drive with multiple memory systems 300 that form a solid state integrated circuit FLASH drive 550.

While at least one exemplary embodiment has been presented in the foregoing detailed description of the invention, it should be appreciated that a vast number of variations exist. It should also be appreciated that the exemplary embodiment or exemplary embodiments are only examples, and are not intended to limit the scope, applicability, or configuration of the invention in any way. Rather, the foregoing detailed description will provide those skilled in the art with a convenient road map for implementing an exemplary embodiment of the invention, it being understood that various changes may be made in the function and arrangement of elements described in an exemplary embodiment without departing from the scope of the invention as set forth in the appended claims and their legal equivalents.

## Claims

1. A memory system (300) for storing data from a plurality of computing devices (410), comprising:
a controller (310) configured to be coupled to the plurality of computing devices (410);
a plurality of Multi-Level Cell (MLC) storage disks (320) coupled to the controller (310) and configured to split storage of the data across the plurality of MLC storage disks (320); and
a Single-Level Cell (SLC) storage disk (330) coupled to the controller (310) and the plurality of MLC storage disks (320), wherein the SLC storage disk (330) is a parity storage disk for the data.

2. The memory system (300) of claim 1, wherein the controller (310), the plurality of MLC storage disks (320), and the SLC storage disk (330) are arranged in a level 3 Redundant Array of Independent Disks (RAID 3) configuration.

3. The memory system (300) of claim 1, wherein the controller (310), the plurality of MLC storage disks (320), and the SLC storage disk (330) are arranged in a level 4 Redundant Array of Independent Disks (RAID 4) configuration.

4. A computing device (500), comprising:
a processor (510); and
a first memory system (300) coupled to the processor (510), the first memory system (300) comprising:
a first memory controller (310),
a first plurality of Multi-Level Cell (MLC) devices (320) coupled to the first memory controller (310) and configured to split the storage of data across the plurality of first MLC devices, and
a first Single-Level Cell (SLC) device (330) coupled to the first memory controller (310) and the first plurality of MLC devices, wherein the first SLC device is a first parity device for the data.

5. The computing device (500) of claim 4, wherein the first plurality of MLC devices are each a MLC FLASH device and the first SLC device is a SLC FLASH device.

6. The computing device (500) of claim 4, wherein the first plurality of MLC devices are each a MLC storage disk and the first SLC device is a SLC storage disk.

7. The computing device (500) of claim 4, wherein the first SLC device is configured to apply a Reed-Solomon protection scheme, an EDAC Hamming protection scheme, or a XORing protection scheme.

8. The computing device (500) of claim 4, further comprising:
a second memory system (300) coupled to the processor (510) and the first memory system (300), the second memory (300) comprising:
a second memory controller (310),
a second plurality of MLC devices coupled to the second memory controller (310) and configured to split the storage of data across the plurality of second MLC devices, and
a second Single-Level Cell SLC device coupled to the second memory controller (310) and the second plurality of MLC devices, wherein the second SLC device is a second parity device for the data.

9. The computing device (500) of claim 8, wherein the first memory system (300) and the second memory system (300) form at least a portion of a FLASH drive system.
